(19) Europäisches Patentamt
European Patent Office
Office européen des brevets

(11) Publication number: **0 499 271 A1**

# (12) EUROPEAN PATENT APPLICATION

(21) Application number: **92102509.4**

(51) Int. Cl.$^5$: **G03F 7/038**

(22) Date of filing: **14.02.92**

(30) Priority: **15.02.91 JP 22225/91**

(43) Date of publication of application:
**19.08.92 Bulletin 92/34**

(84) Designated Contracting States:
**DE FR GB**

(71) Applicant: **KAWASAKI STEEL CORPORATION**
**1-1-28 Kitahonmachi-Dori Chuo-ku**
**Kobe-shi Hyogo-ken 651(JP)**

(72) Inventor: **Enomoto, Norihide, c/o Technical Research Division**
**Kawasaki Steel Corporation, 1, Kawasaki-cho**
**Chiba-shi, Chiba(JP)**
Inventor: **Yamamoto, Seiji, c/o Technical Research Division**
**Kawasaki Steel Corporation, 1, Kawasaki-cho**
**Chiba-shi, Chiba(JP)**
Inventor: **Naruse, Yoshihiro, c/o Technical Research Division**
**Kawasaki Steel Corporation, 1, Kawasaki-cho**
**Chiba-shi, Chiba(JP)**
Inventor: **Asami, Yukio, c/o Chiba Works**
**Kawasaki Steel Corporation, 1, Kawasaki-cho**
**Chiba-shi, Chiba(JP)**

(74) Representative: **Patentanwälte Grünecker, Kinkeldey, Stockmair & Partner**
**Maximilianstrasse 58**
**W-8000 München 22(DE)**

## (54) Photosensitive resin.

(57) A new photosensitive resin prepared by esterifying at least part of an acid anhydride group of a copolymer of indene (or polymerizable components including indenes) and maleic anhydride, optionally, the maleic anhydride partly replaced by maleimide. The negative photosensitive resin of the present invention has high thermal resistance and can be used as a pattern forming material for use in the production of solder resists, etching resists, plating resists and photoresists when it is used alone or combined with other components.

F I G. 1

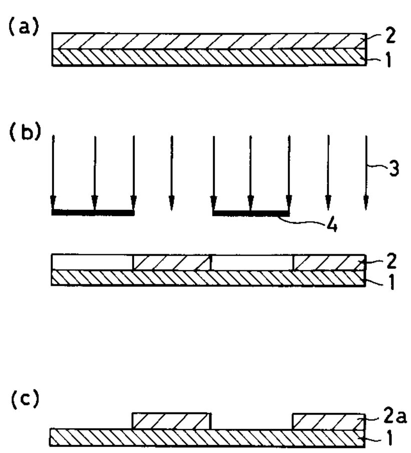


EP 0 499 271 A1

## FIELD OF THE INVENTION

The present invention relates to a new negative photosensitive resin comprising an esterified product of a copolymer of indene and maleic anhydride or an esterified product of a copolymer of indene, maleic anhydride and maleimide. The resin of the present invention can be used as a pattern forming material for use in the production of solder resists, etching resists, plating resists and semiconductor devices when it is used alone or combined with other substances.

## BACKGROUND OF THE INVENTION

It is widely known as a prior art that an alternating copolymer of styrene and maleic anhydride (SMA resin) which is reacted to an unsaturated alcohol and/or a saturated alcohol to esterify the part of an acid anhydride group can be used as a photoresist. US Patent No.4,370,403 proposes a photoresist composition consisting of (a) 2-hydroxyethyl acrylate, (b) an additional ethylene-based compound, (c) a photopolymerization initiator and an SMA resin. Japanese Patent Publication No.63-27924 teaches an aqueous composition which comprises a reaction product between a mono(meth)acrylate derivative of caprolactone diol and a copolymer of styrene and maleic anhydride, polymerizes by light (photosensitive), and can be developed with a water-based developer containing no organic solvent.

Japanese Patent Publication No.63-280245 discloses a photosensitive composition comprising a copolymer resin of styrene and maleic anhydride, and hydroxy (meth)acrylate. Japanese Patent Publication No.2-109052 proposes a photoresist composition comprising an esterified product of a copolymer resin of styrene and maleic anhydride with an unsaturated alcohol and a saturated alcohol.

An alternating copolymer (a copolymer of styrene and maleic anhydride) in which styrene and maleic anhydride are copolymerized in the ratio of 1 to 1 is a thermal resistant resin having a melting point of approximately 160 ° C and a thermal decomposition starting point of approximately 200 ° C.

The term of melting point used herein is defined as a temperature at which the resin viscosity reaches 5,000 poises by FLOW TESTER CFT-500 (Shimazu Seisakusho). A copolymer resin of styrene and maleic anhydride containing an increased content of styrene has a lower melting point and lower thermal resistance than the alternating copolymer. As described in the foregoing, such a copolymer resin of styrene and maleic anhydride is reacted to an unsaturated alcohol for esterification, and the resulting esterified product is used as a photoresist. However, since a copolymer resin of styrene and maleic anhydride has low thermal resistance, especially when it is used as a solder resist composition (solder heat resisting resin), it is peeled in peeling tests on a resist film after being dipped in a solder bath at 260 ° C. Therefore, it has not sufficient thermal resistance.

When the esterified product of a copolymer of styrene and maleic anhydride is used as a pattern forming material for semiconductor devices utilizing its photosensitivity, it has the following problems. A solution containing the esterified product of a copolymer of styrene and maleic anhydride and a proper solvent is coated to a semiconductor substrate. Then the coating is prebaked at 70-90 ° C, and exposed to far ultraviolet or other light. The unexposed portions of the coating are eluted with an alkali solution or an organic solvent and developed to obtain a negative resist pattern. Afterwards, the coating is post-baked at 120- 130 ° C, and dry etched. The post-baking temperature is preferably as high as possible because, in the subsequent process, a highly accurate pattern can be achieved by dry etching. Therefore, the temperature is preferably 160 ° C or more, if possible. However, since the esterified product of a copolymer of styrene and maleic anhydride used as a pattern forming material has low thermal resistance, exposed portions of the material are deformed at the time of post-baking with the result of deteriorated resolution. When the substrate is post-baked at a low temperature, a highly accurate pattern cannot be achieved by dry etching.

As described previously, the esterified product of a copolymer of styrene and maleic anhydride has the problem of thermal resistance after being exposed by light. When it is used as a solder resist, its solder heat resistance must be improved. When the esterified product is used as a pattern forming material for semiconductor devices, exposed portions of the product are deformed at the time of post-baking which is performed at high temperatures to achieve a highly accurate pattern through dry etching. This lowers the resolution of resist patterns. These problems are caused by the low melting point and low thermal decomposing point of a copolymer of styrene and maleic anhydride.

It is therefore an object of the present invention to provide a new resin for photoresists which has higher thermal resistance than a copolymer of styrene and maleic anhydride and which overcomes the aforementioned problems.

## SUMMARY OF THE INVENTION

Namely, the present invention is to provide a photosensitive resin which contains indene and maleic anhydride and wherein at least part of an acid anhydride group of the copolymer of indene and maleic anhydride is esterified with an unsaturated alcohol. Indene and maleic anhydride of the preset invention may be partly replaced with styrene and/or maleimide for some industrial fields.

The alcohol used in the present invention must be an unsaturated alcohol, but a saturated alcohol may be partly used optionally.

BRIEF DESCRIPTION OF THE DRAWING

FIG.1 illustrates the process for forming patterns using the photosensitive resin of the present invention.

DETAILED DESCRIPTION OF THE INVENTION

The present invention will be described in detail.

The inventors have already disclosed a copolymer of indene and maleic anhydride in European Patent Publication EPAO348975, and a copolymer of indene, maleic anhydride and maleimide in European Patent Publication EPAO393685. According to the disclosure of EPAO348975, the thermal decomposition starting point of the copolymer of indene and maleic anhydride is 310 ° C. This temperature is more than 100 ° C higher than 200 ° C of the thermal decomposition starting point of a copolymer of styrene and maleic anhydride which are in the ratio of 1 to 1 (provided in Kobunshi Ronbunshu (Polymer Thesis) Vol.36, No.7, pp.447-453 (1973)). Therefore, the copolymer has high thermal resistance. The glass transition temperature of the copolymer of indene and maleic anhydride is 210 ° C (measured by differential scanning calorimetry DSC), and the melting point is 270 ° C. In contrast, the melting point of the copolymer of styrene and maleic anhydride is around 150 ° C. Therefore, the copolymer of indene and maleic anhydride has higher thermal resistance than the copolymer of styrene and maleic anhydride. According to the disclosure of EPAO393685, a terpolymer of indene, N-phenyl maleimide and maleic anhydride, which is constructed of the compolymer of indene and maleic anhydride partly replaced with maleimide (N-phenyl maleimide), has higher thermal resistance than a copolymer of indene and maleic anhydride.

The inventors have discovered that resins prepared by esterifying at least apart of an acid anhydride group of these copolymers with an unsaturated alcohol have high thermal resistance and photosensitivity, and can be used as a negative pattern forming material for use in the production of solder resists, etching resists, plating resists or semiconductor elements. The present invention is predicated on this discovery.

The esterified copolymer containing indene and maleic anhydride and, optionally, maleimide which is used as a negative photoresist according to the present invention comprises the following recurring units, and is a resin wherein part or all of an acid anhydride group of a recurring unit [C] is esterified with an unsaturated alcohol.

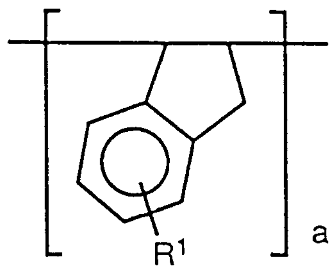

[A]

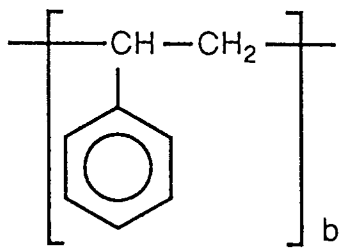

[B]

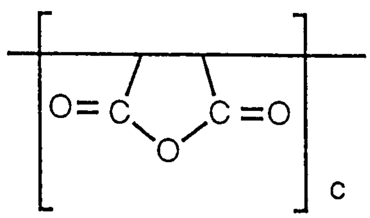

[C]

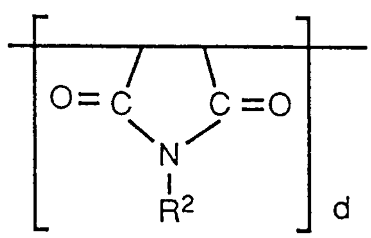

[D]

wherein $R^1$ represents hydrogen or an alkyl group of $C_{1-4}$, and $R^2$ represents at least one group selected from the group consisting of hydrogen, an alkyl group, and an aryl group.

a, b, c and d are natural numbers which represent mol% of each recurring unit based on the total resin, and b and d include 0. These natural numbers are represented by the following equations:

$40 \leqq (a + b) \leqq 60$
$5 \leqq a \leqq 50$
$25 \leqq c \leqq 50$

Indene and methylindene are given as an example of a recurring unit [A], and indene is preferred.

The recurring unit [A] is not limited specifically as far as it is indene alone or polymerizable components containing indene as a main component. It may be coal or petroleum-based mixed oil containing indene as a main component. It is economically better to use the polymerizable components of mixed oil which contains indene as a main component to produce a copolymer.

One example of the composition of polymerizable components contained in mixed oil is given below.

Mixed oil consisting of polymerizable components (X), (Y) and (Z) described below:

(X) indene: 70 to 99 wt%

(Y) styrene: 0.5 to 29.5 wt%

(Z) at least one or total of two or more selected from the group consisting of α-methylstyrene, methylstyrene, dimethylstyrene, trimethylstyrene, coumarone, methylindene and dicyclopentadiene: 0.5 to 29.5 wt%

When polymerizable components containing indene as a main component are used in place of the recurring unit [A], they must be adjusted so that the content of indene contained in the copolymer becomes 5 mol% or more.

The thermal resistance of the copolymer containing indene and maleic anhydride for photosensitive resins becomes higher as the content of indene increases. However, when the copolymer contains at least 5 mol% of indene, it has higher thermal resistance than the copolymer of styrene and maleic anhydride, and can be put to practical use.

The thermal resistance of the copolymer containing indene and maleic anhydride becomes higher as the content of maleimide increases. However, when maleimide is used, the content of an acid anhydride group is lowered by maleic anhydride contained in the resin. Therefore, even if the copolymer is esterified with an unsaturated alcohol, the amount of a double bond introduced into the copolymer reduces, and the amount of a component which polymerizes by light decreases with the result of lowered photosensitivity. For this reason, the content of maleimide must be 25 mol% or less of the copolymer composition. $R^2$ in a recurring unit [D] is an hydrogen atom, an alkyl group having a straight chain or a side chain and 1 to 4 carbons such as methyl, ethyl and propyl, a cyclohexyl group, an aryl group, a condensed aromatic ring or a combination of these groups.

The molecular weight of the esterified copolymer of the present invention preferably ranges from 2,000 to 100,000, and a preferred esterification ratio is such that the total amount of an unsaturated alcohol and a saturated alcohol is 0.1 to 1.8 times the equivalent of an acid anhydride group contained in the copolymer. If the esterification ratio is below this range, patterns are not formed because the copolymer loses developer resistance in an alkali solution. If the esterification ratio is beyond this range, development is impossible. Alcohols and esters thereof are used as an unsaturated alcohol used to esterify at least part of an acid anhydride group of the copolymer containing indene and maleic anhydride for photosensitive resins. Allyl alcohol, hydroxyethyl acrylate, hydroxyethyl methacrylate, hydroxypropyl acrylate and hydroxypropyl methacrylate. They are used alone or in combination of two or more.

The esterification method is not limited specifically, and the general method can be used. To enhance an esterification reaction or shorten the reaction time, an acid catalyst such as sulfuric acid and boron trifluoride can be used. In addition, to prevent the mutual polymerization of unsaturated alcohols, a polymerization inhibitor such as hydroquinone and t-butyl catechol can be used.

Photosensitivity is provided to the esterified product of the present invention by such an unsaturated alcohol. For the control of the developing property using an alkali solution or an organic solvent, substrate adhesion, electric insulating property and chemical resistance of the product, a proper saturated alcohol can also be used.

Saturated alcohols usable with the esterified product of the present invention include propanol, hexanol, cyclohexanol, octanol, 2,3-dibromo-1-propanol, 2,3-dichloro-1-propanol and butylcellosolve (ethylene glycol monobutyl ether). These can be used alone or in combination of two or more.

When a saturated alcohol is used, the mole ratio of a saturated alcohol to an unsaturated alcohol preferably ranges from 0 to 1/1.

The photosensitive resin of the present invention may be blended with a proper photopolymerization initiator, a photosensitive resin or a photosensitive monomer other than the resin of the present invention or resins useful for general purposes such as an epoxy resin, in addition to the aforementioned essential components.

Examples of the photopolymerization initiator include benzophenones such as benzophenone and 4,4'-dimethylamino benzophenone, anthraquinones such as 2-ethyl anthraquinone and tert-butylanthraquinone, and benzoin alkyl ethers such as benzoin ethyl ether and benzoin isopropyl ether, but they are not limited to these.

Examples of the photosensitive monomer include 1,6-hexanediol diacrylate, trimethyrolpropane triacrylate, tetramethylolmethane tetracrylate, dipentaerythritol pentacrylate, but they are not limited to these.

A phenolic novolak type epoxy resin and a cresol-novolak type epoxy resin, both of which are prepared by reacting a phenolic novolak resin or cresol-novolak resin to epichlorohydrin or methylepichlorohydrin, can be used as a blendable epoxy resin. Normally, an epoxy resin is blended with an ethylenically

unsaturated carboxylic acid to enhance polymerization density. Preferable ethylenically unsaturated carboxylic acids include maleic monoester, sorbic acid, acrylic acid, methacrylic acid and crotonic acid.

Furthermore, aromatic amine may be blended as a catalyst for an esterification reaction between the epoxy resin and unsaturated carboxylic acid, or as a curing agent for an epoxy resin.

Moreover, when the photosensitive resin of the present invention is used for other applications such as a solder resist, it can be blended with solid powders to provide a printing ink adhesive property to a photosensitive composition containing the resin of the present invention. Preferable solid powders are inorganic powders such as Aerosil, mica, talc and aluminum oxide, or organic solid powders such as globular particles of benzoguanidines, polyimides and polyamides.

The solvent for dissolving the resin of the present invention or a photoresist composition containing the resin of the present invention is not limited specifically, but is preferably an ether-based solvent such as ethylene glycol monoalkyl ether (alkylcellosolve), propylene glycol monoalkyl ether, diethylene glycol monoalkyl ether, or a ketone-based solvent such as methyl ethyl ketone, methyl isobutyl ketone and cyclohexanone.

The method of forming negative patterns for use in the production of solder resists, etching resists, plating resists or semiconductor elements using the resin of the present invention is not limited specifically, but the preferable method comprises the steps of (1) applying a solution containing the resin as a main component to a substrate, (2) heating and drying the coating at a temperature ranging from 50°C to 100°C to remove the solvent, (3) exposing the coating through a mask pattern to ultraviolet light having a wavelength of 200 to 750 nm, KrF excimer laser light having a wavelength of 249 nm or far ultraviolet light having a wavelength of 190 to 330 nm generated from a light source such as a high-pressure mercury lamp or a metal hallide lamp, and (4) eluting unexposed portions of the coating with an alkali solution such as a solution containing 2% of $Na_2CO_3$ or an organic solvent such as MBK (methyl isobutyl ketone) to form a pattern. Especially for the formation of fine circuit patterns for semiconductor devices, exposure to short-wavelength light such as KrF excimer laser light having a wavelength of 249 nm or far ultraviolet light having a wavelength of 190 to 330 nm is required.

EXAMPLES

The following examples are provided for the purpose of further illustrating the present invention.

(Synthesis Example 1)

A glass reactor with an internal capacity of 500cc (with a stirrer, a dropping funnel, a water cooling pipe, and a nitrogen inlet pipe) was charged with 100cc of toluene as a solvent for reaction. Under agitation with the stirrer, a slight amount of nitrogen gas was always supplied to the reactor which was maintained at 90°C by heating with an external heater. 24.5 g of maleic anhydride, 29 g of indene, and 0.72 g of azobisisobutyronitril as a polymerization initiator, were dissolved in 200cc of toluene and charged into the dropping funnel to drip this solution over approximately two hours. The solution began to form a white precipitate 10 minutes after dripping. Thereafter, the reaction temperature described previously was maintained for five hours for the completion of the reaction.

Then the reaction temperature was returned to room temperature, and a copolymer of indene and maleic anhydride was obtained through filtration. The obtained copolymer of indene and maleic anhydride was 51 g in weight after being dried under reduced pressure, with a weight yield of 95%.

According to GPC (gel permeation chromatography), Mn (number average molecular weight) of the copolymer was 8,000 in terms of polystyrene.

(Synthesis Examples 2 to 10)

A copolymer of indene and maleic anhydride was synthesized as in Synthesis Example 1. The reaction temperature, type of a polymerization solvent, type and quantity (in g) of an initiator used, the quantity (in g) of each polymerizable component, yield, and Mn of the resulting indene-maleic anhydride copolymer are shown in the table below. The quantity of maleic anhydride used and the quantity of a solvent used are the same as those of Synthesis Example 1. When MEK (methyl ethyl ketone) and MIBK (methyl isobutyl ketone) were used as a polymerization solvent, the reacted solution was poured into hexane after reaction to deposit. The precipitate was separated through filtration and dried as a copolymer of indene and maleic anhydride.

The results obtained are shown in Table 1. Abbreviations for polymerization initiators shown in Tables 1

to 3 are given below.
AIBN: azobisisobutyronitril
PERHEXA 3M: radical polymerization initiator manufactured by Nippon Oil and Fats Co., Ltd.
BPO: benzoyl peroxide

Table 1

| Synthesis Example | Polymerization Condition | | | | | | Yield (g) | Mn |
|---|---|---|---|---|---|---|---|---|
| | Temp. (°C) | Solvent | Initiator (g) | | Component | | | |
| | | | | | indene (g) | styrene (g) | | |
| 1 | 90 | toluene | AIBN | 0.72 | 29 | 0 | 51 | 8000 |
| 2 | 65 | benzene | AIBN | 0.36 | 29 | 0 | 50.8 | 36000 |
| 3 | 65 | benzene | AIBN | 0.36 | 17.4 | 10.4 | 48.6 | 34000 |
| 4 | 70 | MEK | PERHEXA 3M | 0.37 | 4.35 | 22.1 | 46.9 | 47000 |
| 5 | 70 | toluene | PERHEXA 3M | 0.37 | 24.65 | 3.9 | 50.4 | 50000 |
| 6 | 80 | toluene | BPO | 1 | 29 | 0 | 50.8 | 13000 |
| 7 | 100 | toluene | AIBN | 0.72 | 20.3 | 7.8 | 48.4 | 5000 |
| 8 | 110 | toluene | AIBN | 0.72 | 26.1 | 2.6 | 48.4 | 4000 |
| 9 | 110 | MIBK | BPO | 1 | 10.15 | 16.9 | 46.4 | 3700 |
| 10 | 130 | cumene | BPO | 1 | 24.65 | 3.9 | 49.3 | 2000 |

(Synthesis Examples 11 to 20)

As in Synthesis Example 1, a copolymer of indene and maleic anhydride was synthesized using naphtha oil. The reaction temperature, type of a polymerization solvent, type and quantity (in g) of an initiator, the quantity (in g) of each polymerizable component, yield, and Mn (number average molecular weight) of the resulting copolymer of indene and maleic anhydride are shown in Table 2. The quantity of maleic anhydride used and the quantity of a solvent used are the same as those of Synthesis Example 1. When MEK (methyl ethyl ketone) and MIBK (methyl isobutyl ketone) were used as a polymerization solvent, the reacted solution was poured into hexane after reaction to deposit. The precipitate was separated through filtration and dried as a copolymer of indene and maleic anhydride.

(X), (Y) and (Z) of the composition of naphtha oil in Table 2 are the following polymerizable components.

(X) indene

(Y) styrene

(Z) total amount of at least one, or two or more selected from the group consisting of α-methylstyrene, methylstyrene, dimethylstyrene, trimethylstyrene, methylindene, coumarone and dicyclopentadiene.

Table 2

| Synthesis Example | Polymerization Condition | | | | Naphtha oil | | | | | styrene (g) | Yield (g) | Mn |
|---|---|---|---|---|---|---|---|---|---|---|---|---|
| | Temp. (°C) | Solvent | Initiator (g) | | Total (g) | Contents*1 (wt%) | X*2 (wt%) | Y*3 (wt%) | Z*4 (wt%) | | | |
| 11 | 65 | benzene | AIBN | 0.36 | 58.0 | 50 | 75 | 5 | 20 | 0.0 | 50.8 | 38000 |
| 12 | 65 | benzene | AIBN | 0.36 | 48.3 | 45 | 80 | 4 | 16 | 6.5 | 47.5 | 31000 |
| 13 | 70 | MEK | PERHEXA 3M | 0.37 | 9.1 | 80 | 95 | 2 | 3 | 19.5 | 47.2 | 44000 |
| 14 | 70 | toluene | PERHEXA 3M | 0.37 | 66.3 | 35 | 70 | 15 | 15 | 5.2 | 49.2 | 52000 |
| 15 | 80 | toluene | BPO | 1 | 31.1 | 70 | 70 | 20 | 10 | 6.5 | 47.5 | 12500 |
| 16 | 100 | toluene | AIBN | 0.72 | 53.9 | 35 | 80 | 10 | 10 | 9.1 | 49.3 | 5200 |
| 17 | 110 | toluene | AIBN | 0.72 | 34.8 | 75 | 85 | 4 | 11 | 2.6 | 49.5 | 4100 |
| 18 | 110 | MIBK | BPO | 1 | 21.8 | 40 | 90 | 6 | 4 | 18.2 | 47.3 | 3600 |
| 19 | 120 | cumene | BPO | 1 | 77.3 | 30 | 95 | 1 | 4 | 5.2 | 48.1 | 2800 |
| 20 | 130 | cumene | BPO | 1 | 39.0 | 52 | 90 | 6 | 4 | 7.8 | 49.4 | 1800 |

*1: contents of polymerizable component of naphtha oil
*2: contents of component X based on the total polymerizable composition of naphtha oil
*3: contents of component Y based on the total polymerizable composition of naphtha oil
*4: contents of component Z based on the total polymerizable composition of naphtha oil

(Comparative Synthesis Examples 1 to 7)

An alternating copolymer of styrene and maleic anhydride was synthesized as in Synthesis Examples 1 to 4 for comparison. The quantity of maleic anhydride used and the quantity of a polymerization solvent

used are the same as those of Synthesis Example 1. The number average molecular weight of a resulting copolymer is shown in Table 3.

Table 3

| Comparative Synthesis Example | Polymerization Condition | | | | | Yield (g) | Mn |
|---|---|---|---|---|---|---|---|
| | Temp. (°C) | Solvent | Initiator (g) | | styrene (g) | | |
| 1 | 65 | MEK | AIBN | 0.36 | 26.0 | 47.0 | 40000 |
| 2 | 70 | MEK | PERHEXA 3M | 0.37 | 26.0 | 48.0 | 55000 |
| 3 | 80 | MEK | BPO | 1 | 26.0 | 49.0 | 14000 |
| 4 | 100 | MIBK | AIBN | 0.72 | 26.0 | 50.0 | 5500 |
| 5 | 110 | MIBK | BPO | 1 | 26.0 | 47.0 | 3700 |
| 6 | 120 | MIBK | BPO | 1 | 26.0 | 49.0 | 2600 |
| 7 | 130 | MIBK | BPO | 1 | 26.0 | 48.0 | 1900 |

(Synthesis Examples 21 to 30)

The following copolymers were synthesized as in synthesis examples.

The reaction temperature, type of a polymerization solvent, type and quantity (in g) of an initiator, the quantity (in g) of each polymerizable component, yield (in g) and Mn (number average molecular weight) of the resulting copolymer are shown in Table 4. The treatment method when MEK and MIBK are used as a polymerization solvent is the same as the aforementioned synthesis examples.

Table 4

| Synthesis Example | Polymerization Condition | | | | polymer component (g) | | | | maleimide | Yield (g) | Mn |
|---|---|---|---|---|---|---|---|---|---|---|---|
| | Temp. (°C) | Solvent | Initiator(g) | | indene | styrene | maleic anhydride | maleimide | | | |
| 21 | 65 | benzene | AIBN | 0.36 | 29 | 0 | 22.05 | 4.325 | phenylmaleimide | 52.6 | 34000 |
| 22 | 65 | benzene | AIBN | 0.36 | 17.4 | 10.4 | 17.15 | 8.325 | methylmaleimide | 49.0 | 38000 |
| 23 | 70 | MEK | PERHEXA 3M | 0.37 | 2.9 | 23.4 | 14.7 | 15.3 | butylmaleimide | 52.4 | 43000 |
| 24 | 70 | toluene | PERHEXA 3M | 0.37 | 26.1 | 2.6 | 12.25 | 22.375 | cyclohexyl-maleimide | 57.6 | 51000 |
| 25 | 80 | toluene | BPO | 1 | 14.5 | 13 | 17.15 | 12.975 | phenylmaleimide | 54.7 | 14000 |
| 26 | 100 | toluene | AIBN | 0.72 | 5.8 | 20.8 | 19.6 | 5.55 | methylmaleimide | 47.6 | 5500 |
| 27 | 110 | toluene | AIBN | 0.72 | 23.2 | 5.2 | 17.15 | 11.475 | butylmaleimide | 53.0 | 4500 |
| 28 | 110 | MIBK | BPO | 1 | 20.3 | 7.8 | 14.7 | 13.9 | propylmaleimide | 51.6 | 3600 |
| 29 | 130 | cumene | BPO | 1 | 8.7 | 18.2 | 12.25 | 21.625 | phenylmaleimide | 57.1 | 1800 |
| 30 | 130 | cumene | BPO | 1 | 5.8 | 20.8 | 22.05 | 4.475 | cyclohexyl-maleimide | 48.9 | 2200 |

(Examples 1 to 9) and (Comparative Examples 1 and 2)

Copolymers of indene and maleic anhydride and copolymers of styrene and maleic anhydride synthesized in synthesis examples and comparative synthesis examples were esterified as shown in Table 5. After isolation, they were each diluted with ethylene glycol monobutylether (butylcellosolve) into 60 wt% to prepare a resin solution.

Copolymers of indene and maleic anhydride and copolymers of styrene and maleic anhydride prepared in synthesis examples and comparative synthesis examples were esterified with unsaturated alcohols and/or saturated alcohols in accordance with the general method shown in Table 5. To enhance esterification reaction or shorten the reaction time, an appropriate acid catalyst is required. In addition, to prevent the mutual polymerization of unsaturated alcohols, a polymerization inhibitor such as hydroquinone must be added. The esterification ratios with unsaturated alcohols and saturated alcohols were measured by the NMR (nuclear magnetic resonance) method based on the following equitation.

$$\text{esterification ratio (\%)} = \frac{\text{esterified carboxyl group (mole)}}{2 \times \text{(acid anhydride group (mole) of a resin before esterification)}} \times 100$$

Table 5

| Example | copolymer | unsaturated alcohol | esterification ratio, % | saturated alcohol | esterification ratio, % |
|---|---|---|---|---|---|
| Ex. 1 | synthesis Ex. 1 | allyl alcohol | 35 | cyclohexanol | 25 |
| Ex. 2 | synthesis Ex. 7 | HEMA | 65 | - | |
| Ex. 3 | synthesis Ex. 9 | allyl alcohol | 33 | butylcellosolve | 20 |
| Ex. 4 | synthesis Ex. 15 | HEA | 35 | cyclohexanol | 30 |
| Ex. 5 | synthesis Ex. 18 | HEMA | 45 | - | |
| Ex. 6 | synthesis Ex. 20 | HEMA | 30 | propanol | 35 |
| Ex. 7 | synthesis Ex. 22 | HEA | 70 | - | |
| Ex. 8 | synthesis Ex. 25 | HEMA | 50 | butylcellosolve | 15 |
| Ex. 9 | synthesis Ex. 29 | allyl alcohol | 45 | cyclohexanol | 25 |
| Comparative Ex. 1 | Comparative synthesis Ex. 4 | allyl alcohol | 35 | cyclohexanol | 25 |
| Comparative Ex. 1 | Comparative synthesis Ex. 6 | HEA | 40 | - | |

Note) HEA: hydroxyethyl acrylate
HEMA: hydroxyethyl methacrylate

Using the resulting butylcellosolve solution of the esterified copolymers, the following compositions were prepared.

| | |
|---|---|
| (1) butylcellosolve solution containing an esterified copolymer (60 wt%) | 100 parts by weight |
| (2) diethylthioxanthone | 5 parts by weight |
| (3) 2,2-dimethoxy-2-phenyl-acetophenon | 2 parts by weight |
| (4) AEROSIL #300 (manufactured by Nippon Aerosil) | 8 parts by weight |
| (5) silicone-based anti-foaming agent | 1 part by weight |

Compositions (1) to (5) were mixed to prepare a homogeneous solution. After the solution was applied to the surface of a copper laminated sheet with a roll coater, the coating was dried for 30 minutes in the atmosphere of 80 °C. Then it was exposed to 900 mJ/$cm^2$ ultraviolet light through a negative mask, and

then unexposed portions thereof were eluted with an alkali solution to form a pattern. Thereafter, it was heated at 180° C. Peeling and residual films after the heating were not observed in the resulting patterns of Examples 1 to 9. However, when photoresist compositions comprising esterified products of copolymers of styrene and maleic anhydride prepared in Comparative Examples 1 and 2 were used, formed patterns deformed or partly peeled.

(Examples 10 to 17) and (Comparative Examples 3 and 4)

Copolymers of indene and maleic anhydride and copolymers of styrene and maleic anhydride prepared in synthesis examples and comparative synthesis examples were esterified as shown in Table 6. After isolation, they were each diluted with ethylene glycol monobutylether (butylcellosolve) into 60 wt% to prepare a resin solution.

Table 6

| Example | copolymer | unsaturated alcohol | esterification ratio, % | saturated alcohol | esterification ratio, % |
|---|---|---|---|---|---|
| Ex. 10 | synthesis Ex. 8 | allyl alcohol | 40 | cyclohexanol | 25 |
| Ex. 11 | synthesis Ex. 9 | HEA | 55 | - | |
| Ex. 12 | synthesis Ex. 10 | allyl alcohol | 38 | butylcellosolve | 20 |
| Ex. 13 | synthesis Ex. 15 | HEMA | 40 | cyclohexanol | 30 |
| Ex. 14 | synthesis Ex. 16 | allyl alcohol | 45 | - | |
| Ex. 15 | synthesis Ex. 19 | HEMA | 35 | propanol | 35 |
| Ex. 16 | synthesis Ex. 21 | HEA | 55 | propanol | 20 |
| Ex. 17 | synthesis Ex. 30 | HEMA | 45 | - | |
| Comparative Ex. 3 | Comparative synthesis Ex. 5 | allyl alcohol | 35 | butylcellosolve | 25 |
| Comparative Ex. 4 | Comparative synthesis Ex. 7 | HEMA | 55 | - | |

Note) HEA: hydroxyethyl acrylate
HEMA: hydroxyethyl methacrylate

Using the resulting butylcellosolve resin solution, the following compositions were prepared.

| | |
|---|---|
| (1) butylcellosolve solution containing an esterified copolymer (60 wt%) | 100 parts by weight |
| (2) esterified bisphenol A type epoxy resin | 60 parts by weight |
| (3) trimethyrolpropane-triacrylate | 8 parts by weight |
| (4) 4,4-diethylaminophenone | 2 parts by weight |
| (5) aerosil #300 (manufactured by Nippon Aerosil) | 8 parts by weight |
| (6) silicone-based anti-foaming agent | 1 part by weight |

Compositions (1) to (6) were mixed together to prepare a homogeneous solution. After the solution was

applied through a 150-mesh screen made of TETRON® to the surface of a printed circuit board on which circuits have been provided, the coating was dried for 30 minutes in the atmosphere of 80° C. Then it was exposed to 600 mJ/cm$^2$ ultraviolet light through a negative mask. Thereafter, unexposed portions of the coating were eluted with an alkali solution to form a pattern. Furthermore, it was heated at 180° C for 60 minutes for thermal curing in order to achieve a printed circuit board having the resin coating film formed thereupon. A boiling test was conducted on this printed circuit board by boiling it in ethylene glycol monoethyl ether for 30 minutes. In addition, a peeling test was conducted on the board using CELLOPHANE® tape after 30 seconds of dipping in a molten solder bath heated at 260° C.

As a result, after 30 minutes of boiling tests using ethylene glycol monoethyl ether, no pattern changes were observed in printed circuit boards which used compositions including resins prepared in Examples 10 to 17 as a resist material. Furthermore, no peeling was seen during peeling tests after dipping in a solder bath. Therefore, the resin coating films had high thermal resistance and a high adhesive property. However, swollen patterns were observed in printed circuit boards which used compositions including copolymers of styrene and maleic anhydride prepared in Comparative Examples 3 and 4 as a photoresist after 30 minutes of boiling tests using ethylene glycol monoethyl ether. According to peeling tests after dipping in a solder bath, partial peeling was observed. Therefore, it was proved that the resin films of Comparative Examples 3 and 4 had low thermal resistance and a low adhesive property.

(Examples 18 to 22), (Comparative Examples 5 and 6)

Five grams of an esterified copolymer prepared in each of examples and comparative examples described in the foregoing and 21g of diethylene glycol dimethyl ether were mixed to prepare a photoresist solution.

Table 7

| | Esterified Copolymer Used |
|---|---|
| Example 18 | Example 2 |
| Example 19 | Example 7 |
| Example 20 | Example 11 |
| Example 21 | Example 15 |
| Example 22 | Example 17 |
| Comparative Example 5 | Comparative Example 2 |
| Comparative Example 6 | Comparative Example 4 |

Using the resultant photoresist solution, a negative pattern was formed on a semiconductor substrate by the process illustrated in FIG.1.

As shown in FIG.1(a), a photoresist solution was rotationally applied to a substrate 1 for use in semiconductors to produce a 1.5 µm thick resist film. The film was then prebaked at 90° C for one hour to achieve a photoresist film 2.

Then the photoresist film 2 was selectively exposed to the pulses of 249nm KrF excimer laser light 3 through a mask 4 as shown in FIG.1(b).

Finally, as shown in FIG.1(c), the film 2 was subjected to normal alkali development treatment to remove unexposed portions thereof and achieve a negative resist pattern 2a.

Thereafter, the film 2 was post-baked at 160° C for 30 minutes before dry etching to increase polymerization density.

In either case of Examples 18 to 22, the resist pattern 2a after post-baking was a high-contrast fine pattern (0.25 µm) precisely in accordance with a mask design, and dry etching produced a good result. However, the resist patterns 2a of Comparative Examples 4 and 5 deformed and had lowered resolution.

(Examples 23 to 27, Comparative Examples 7 and 8)

Five grams of an esterified product shown in Table 8 and prepared in each of examples and comparative examples were dissolved in 1g of benzyldimethylketal as a photosensitizer and 20g of butylcellosolve to prepare a butylcellosolve solution containing a photoresist (photoresist solution).

Table 8

| | Esterified copolymer Used |
|---|---|
| Example 23 | Example 1 |
| Example 24 | Example 7 |
| Example 25 | Example 11 |
| Example 26 | Example 15 |
| Example 27 | Example 17 |
| Comparative Example 7 | Comparative Example 2 |
| Comparative Example 8 | Comparative Example 4 |

As shown in FIG.1(a), the photoresist solution was applied twice to a semiconductor substrate 1 to produce a 1.5 µm thick resist film. The film was pre-baked at 90 °C for one hour.

Then the photoresist film 2 was selectively exposed through a mask 4 to the pulses of a KrF excimer laser light 3 having a wavelength of 249 nm as shown in FIG.1(b).

Thereafter, the film 2 was developed with MIBK (methyl isobutyl ketone) for one minute to remove unexposed portions thereof, and was rinsed with IPA (isopropyl alcohol) for 30 seconds.

Finally, the film 2 was post-baked at 180 °C for 30 minutes to obtain a negative resist pattern 2a.

In either case of Examples 23 to 27, the resist pattern 2a after post-baking is a high-contrast fine pattern (0.25 µm) precisely in accordance with a mask design, and dry etching produced a good result. However, the resist patterns of Comparative Examples 7 and 8 deformed and had lowered resolution.

INDUSTRIAL APPLICABILITY

The new photosensitive resin of the present invention has high thermal resistance and can be suitably used as a photoresist for forming patterns for use in the production of solder resists, etching resists, plating resists or semiconductor devices.

## Claims

1. A photosensitive resin comprising the following recurring units, wherein at least a part or all of an acid anhydride group of a recurring unit [C] is esterified with an unsaturated alcohol,

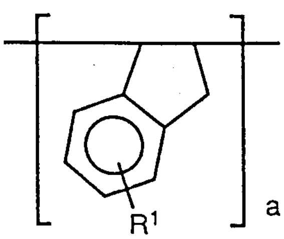

[A]

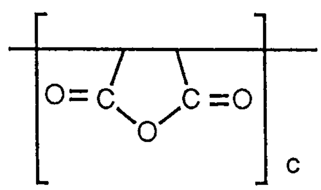

[C]

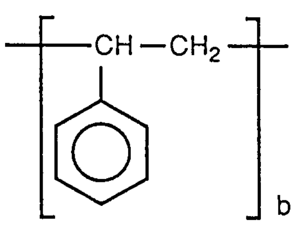

[B]

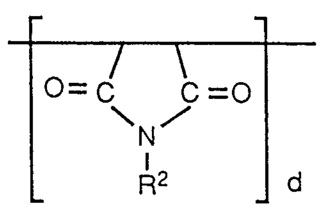

[D]

wherein $R^1$ represents hydrogen or an alkyl group of $C_{1-4}$, and $R^2$ represents at least one group selected from the group consisting of hydrogen, an alkyl group and an aryl group, a, b, c and d being natural numbers which represent mol% of each recurring unit based on the total resin, and b and d including 0, with the proviso that these natural numbers are represented by the following equations.

$40 \leqq (a + b) \leqq 60$
$5 \leqq a \leqq 50$
$25 \leqq c \leqq 50$

**2.** The resin according to claim 1, wherein 0.1 to 1.8 times the equivalent of said unsaturated alcohol is used for said esterification to said acid anhydride group in said recurring unit [C].

**3.** The resin according to claim 1, wherein said recurring unit [A] is replaced with a mixture of polymerizable components comprising:

(X) 70 to 99 wt% of indene,
(Y) 0.5 to 29.5 wt% of styrene, and
(Z) 0.5 to 29.5 wt% of at least one selected from the group consisting of α-methylstyrene, methylstyrene dimethylstyrene, trimethylstyrene, coumarone, methylindene and dicyclopentadiene.

**4.** A resin according to claim 1 or 3, wherein said unsaturated alcohol is at least one selected from the group consisting of allyl alcohol, hydroxyethyl acrylate and hydroxyethyl methacrylate. 5. A method for forming a photoresist pattern comprising the steps of:
applying a solution comprising said resin according to claim 1 or 3 as a main component to a substrate,
drying said resin to remove the solvent,
exposing said photoresist to light through a mask, and
eluting unexposed portions of said resin with an alkali solution.

FIG. 1

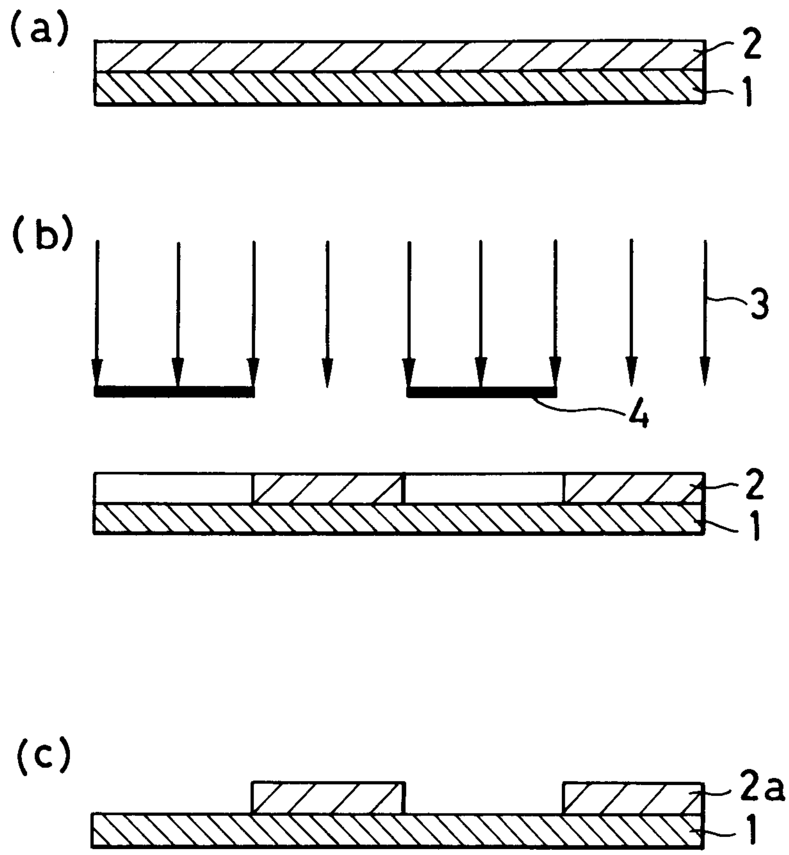

European Patent Office

# EUROPEAN SEARCH REPORT

Application Number

EP 92 10 2509

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y,D | EP-A-0 393 685 (KAWASAKI STEEL CORP.) * claims; page 10, table 3 * | 1-4 | G 03 F 7/038 |
| Y | EP-A-0 106 351 (MITSUBISHI CHEMICAL IND.) * claims; page 22, reference 2 * | 1-4 | |
| A | PATENT ABSTRACTS OF JAPAN vol. 11, no. 264 (P-610)(2711), 27 August 1987; & JP - A - 6269262 (TOSHIBA CORP.) 30.03.1987 | 1 | |
| A | FR-A-2 253 772 (QUADRIMETAL OFFSET) * claims * | 1,4 | |
| A,D | EP-A-0 348 975 (KAWASAKI STEEL CORP.) * claims * | 1-3 | |
| A | EP-A-0 410 794 (HOECHST CELANESE CORP.) * claims; page 7, lines 1-29 * | 1 | TECHNICAL FIELDS SEARCHED (Int. Cl.5) |
| | | | G 03 F 7/00 |

The present search report has been drawn up for all claims

| Place of search | Date of completion of the search | Examiner |
|---|---|---|
| BERLIN | 20-05-1992 | STOCK H |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)